# EUROPÄISCHE PATENTSCHRIFT

(11) **EP 1 120 670 B1**
(45) Veröffentlichungstag und Bekanntmachung des Hinweises auf die Patenterteilung: **05.10.2005**
(21) Anmeldenummer: 00127427.3
(22) Anmeldetag: 14.12.2000
(51) Int. Cl.: G02B 5/18, G02B 5/02, G02F 1/33

(54) **Adaptronischer Spiegel**
Adaptable mirror
Miroir adaptable

(30) Priorität: 14.01.2000 DE 10001291
(43) Veröffentlichungstag der Anmeldung: 01.08.2001
(73) Patentinhaber: Carl Zeiss SMT AG, 73446 Oberkochen (DE)
(72) Erfinder: Dinger, Udo, Dr., 73447 Oberkochen (DE); Ross-Messemer, Martin, Dr., 73457 Essingen (DE)
(74) Vertreter: Sawodny, Michael-Wolfgang

(56) Entgegenhaltungen:
- EP-A- 0 517 239
- US-A- 3 633 995
- US-A- 3 633 996
- US-A- 3 931 592
- US-A- 4 157 863
- US-A- 4 216 440
- US-A- 5 825 844

## Beschreibung

Die Erfindung betrifft eine optische Vorrichtung für Strahlungen mit einer Wellenlänge ≤ 160 nm, vorzugsweise EUV-Strahlung mit einem Spiegel mit einer Spiegeloberfläche sowie einer Einrichtung zur Erzeugung von elastischen Schwingungen der Spiegeloberfläche aufgrund von Oberflächendeformationen sowie eine Verwendung eines derartigen Bauteiles, ein Verfahren zur Ausleuchtung eines vorgegebenen Winkelbereiches durch eine Lichtquelle mit einem derartigen Bauteil sowie ein Verfahren zur Herstellung einer derartigen optischen Vorrichtung.

Bei Bauteilen für die Optik, insbesondere die Lithographie mit Wellenlängen ≤ 160 nm, beispielsweise im EUV-Bereich, stellt sich das Problem, daß zum einen zur Vermeidung von Streuungen außerhalb des Bildfeldes bzw. zur Erzielung hoher Reflektivitäten extrem geringe Restrauhigkeiten von 0,1 bis 0,5 nm im HSFR-(High-Spatial-Frequency-Range), welcher im Bereich >1000 mm ⁻¹ liegt, gefordert werden, andererseits für bestimmte Anwendungsgebiete eine vergleichsweise hohe Rauhigkeit ( 1nm - 100 nm ) im MSFR-(Middle-Spatial-Frequency-Range)Bereich, welcher zwischen 1000 mm ⁻¹ und 1 mm ⁻¹ liegt, gefordert wird. Ein Bauteil mit einer derartigen Oberflächenspezifikation ist beispielsweise ein Diffusor für die Optik mit Wellenlängen ≤ 160nm, vorzugsweise für eine Verwendung im EUV-Bereich.

Derartige Oberflächenspezifikationen können für statische Bauteile mit einem Polierprozeß praktisch nicht erreicht werden.

Aufgabe der Erfindung ist es daher, für Optiken, bei denen Wellenlängen ≤ 160 nm verwendet werden, eine optische Vorrichtung anzugeben, mit der diese Oberflächenspezifikationen erfüllt werden können.

Erfindungsgemäß wird diese Aufgabe durch eine aktive optische Vorrichtung gemäß Anspruch 1.

Aus der US 4,346,965 ist ein akusto-optischer Modulator/Deflektor bekannt geworden, bei dem ein Lichtstrahl unter einem derartigen Winkel in ein Substrat eingeleitet wird, daß an einer inneren Substratoberfläche vollständige interne Reflexion auftritt. Die innere Substratoberfläche wiederum ist als aktive Substratoberfläche ausgestaltet, an deren Oberfläche Oberflächenwellen ausgebildet werden, so daß die auf die Substratoberfläche auftreffende Strahlung reflektiert bzw. in die erste Ordnung gebeugt wird. Da Licht mit einer Wellenlänge ≤ 160 nm Festkörper praktisch nicht mehr transmittieren kann, andererseits aber gemäß der US-A-4,346,965 Licht in die Substratoberfläche eindringen muß, ist die aus der US-A-4,346,965 bekannte Anordnung für Licht mit einer Wellenlänge ≤ 160 nm nicht geeignet.

Ein aktives optisches Bauteil für die EUV-Lithographie ist, d. h. Wellenlängen von 13 nm, aus der US-A-5.825.844 bekannt geworden. Bei dem Bauteil gemäß der US-A-5.825.844 handelt es sich um eine optische Vorrichtung mit einem Spiegel mit Spiegeloberfläche, wobei Schwingungen der Spiegeloberfläche durch Oberflächendeformationen angeregt werden können. Allerdings werden bei der Vorrichtung gemäß der US-A-5.825.844 auf die Oberfläche auftreffende Strahlen lediglich reflektiert, das heißt Einfalls- und Ausfallswinkel sind identisch. Der maximale Ablenkwinkel ist dann auf ± 2.5 mrad eingeschränkt.
Die Vorrichtung der US-A-5.825.844 ist des weiteren darauf beschränkt, daß durch aktive Schwingungsanregung eventuelle makroskopische Beschädigungen der Spiegeloberfläche, beispielsweise Staubpartikel oder Kratzer, ausgemittelt werden.

Die Erfinder haben nun erkannt, daß ein wesentlich größerer Winkelbereich von beispielsweise ± 12 mrad dann durchlaufen werden kann,wenn statt Reflexion Beugung an der Außenseite der Spiegeloberfläche erfolgt. Des weiteren ist es möglich, durch Beugung an durch Oberflächenwellen hervorgerufenen Gittern, deren Frequenz kontinuierlich variiert wird, im zeitlichen Mittel eine vollständig homogene Ausleuchtung des Winkelbereiches von ± 12 mrad zu erreichen. Im Gegensatz zur Reflexion wird nämlich bei der Beugung Licht genutzt, das in die 1. und - 1. Beugungsordnung des von der Oberflächenwelle erzeugten Gitters fällt und dessen Ausfallswinkel sich daher vom Einfallswinkel unterscheidet. Im Gegensatz zur Reflexion, bei der das einfallende Licht so auf die Spiegeloberfläche auftrifft, daß es weniger als eine Wellenlänge des durch die Oberflächenwelle erzeugten akustischen Gitters ausleuchtet, werden bei der Beugung eine große Anzahl von Gitterlinien, beispielsweise mehr als 100 Gitterlinien, getroffen.

Die Wellenlänge der akustischen Oberflächenwelle liegt im Bereich 1 µm bis 50 µm und die Amplitude im Bereich 1 nm bis 100 nm. Mit derartigen Werten kann man ein Verhältnis von Amplitude zu Wellenlänge von 1:400 erreichen und damit Beugungswinkel von bis zu ± 12 mrad.

In einer fortgebildeten Ausführungsform der Erfindung ist vorgesehen, daß die Frequenz der Oberflächenwellen bzw. Surface Acustic Waves (SAW) kontinuierlich variiert wird, was gleichbedeutend mit einer kontinuierlichen Variation der Gitterperiode ist, so daß alle Beugungswinkel einer Quelle von 0 mrad bis beispielsweise ± 12 mrad eingestellt werden können.

Zur Modifikation des Einfallstrahles in mehr als einer Dimension, beispielsweise in zwei Dimensionen, ist es vorteilhaft, wenn an mehreren Orten der Spiegeloberfläche Einrichtungen zur Erzeugung elastischer Schwingungen vorgesehen sind, so daß akustische Oberflächenwellen parallel oder nicht parallel auf die aktive Spiegeloberfläche gebracht werden können.

Ist die Größe der aktiven Spiegeloberfläche nicht ausreichend, beispielsweise wegen der beschränkten Größe von Piezokristallen, so wird in einer weitergebildeten Ausführungsform vorgeschlagen, die aktive Spiegeloberfläche aus mehreren Einzelbauteilen zusammenzusetzen, um so die aktive Spiegelfläche zu vergrößern.

In einer ersten praktischen Ausführungsform der Erfindung ist vorgesehen, daß die Einrichtung zur Erzeugung elastischer Schwingungen der Spiegeloberfläche eine piezoelektrische Folie umfaßt. Besonders bevorzugt ist es, wenn die piezoelektrische Folie auf der einen, rauhen Seite eines ausreichend dünnen Substrates aufgebracht wird, wobei die andere Seite des Substrates die Spiegeloberfläche für die auftreffende Strahlung ausbildet.

Die piezoelektrische Folie kann beispielsweise eine PZT-Folie wie in den VDI-Nachrichten vom 04.12.1989 offenbart, ausgebildet sein. Das Substrat, auf das die piezoelektrische Folie aufgebracht wird, ist ein dünnes Si-Substrat, beispielsweise ein Si-Wafer. Die piezoelektrische Folie ist vorzugsweise mittels atomarer Verbindungstechniken, beispielsweise einer TiPt-Verbindung, aufgebracht

Alternativ zu einer Ausgestaltung der Erfindung mit einer auf einem Substrat aufgebrachten piezoelektrischen Folie ist es auch möglich, daß das gesamte piezoelektrische Element aus einem piezoelektrischen Einkristall besteht.

Zur Erzeugung der elastischen Schwingungen der Spiegeloberfläche werden auf die piezoelektrischen Elemente in einer ersten Ausgestaltung der Erfindung punkt- oder linienförmige Elektroden verwandt.

Ein erfindungsgemäßes optisches Bauteil kann Verwendung insbesondere in einer Belichtungseinrichtung für die Mikrolithographie mit Wellenlängen ≤ 160 nm, insbesondere in der EUV-Lithographie finden.

Mögliche Bauteile sind in einer derartigen Belichtungseinrichtung beispielsweise Mittel zur Strahlaufweitung der Lichtquelle, sogenannte Diffusoren, Mittel zur Variation des Beleuchtungssettings sowie Mittel zur Homogenisierung der Ausleuchtung der Pupille.

Neben der Vorrichtung stellt die Erfindung auch ein Verfahren zur Ausleuchtung eines vorgegebenen Winkelbereiches durch eine Lichtquelle mit einer Wellenlänge ≤ 160 nm, vorzugsweise einer EUV-Lichtquelle mit einer erfindungsgemäßen optischen Vorrichtung, zur Verfügung. Das Verfahren umfaßt dabei zunächst den Schritt, daß mindestens eine Oberflächenwelle vorbestimmter Amplitude und Frequenz auf der Spiegeloberfläche erzeugt wird, wobei die Frequenz derart gewählt wird, daß das von der Lichtquelle einfallende Licht eine große Anzahl von durch die Oberflächenwelle erzeugten Gitterlinien trifft. Anschließend wird die Frequenz der Oberflächenwelle in einem vorbestimmten Frequenzbereich kontinuierlich variiert, so daß im zeitlichen Mittel eine homogene Ausleuchtung in einem vorgegebenen Winkelbereich erreicht wird, der bevorzugt zwischen -12,0 mrad ≤ α ≤ 12,0 mrad liegt.

Bei einem besonders bevorzugten Herstellungsverfahren eines erfindungsgemäßen optischen Bauteils wird zunächst eine Seite eines piezoelektrischen Substrates superpoliert, so dass die Oberflächenrauhigkeit weniger als 0,5 nm beträgt zur Anregung akustischer Oberflächenwellen werden auf der Substratoberfläche, bevorzugt auf der superpolierten Substratoberfläche Elektroden aufgebracht. In einer alternativen Ausführungsform kann auf die rauhe Seite des Subtrates eine piezoelektrische Folie aufgebracht werden, die mit Hilfe atomarer Techniken mit der rauhen Seite des Substrates verbunden wird, wobei an der piezoelektrischen Folie die Elektroden zur Anregung von akustischen Oberflächenwellen angebracht werden.

In einem weiteren Herstellungsverfahren wird zunächst eine Seite eines Substrates superpoliert, so dass die Oberflächenrauhigkeit weniger als 0,5 nm beträgt. Sodann werden an der piezoelektrischen Folie Elektroden zur Anregung von akustischen Oberflächenwellen aufgebracht.

Die Erfindung soll nachfolgend anhand der Figuren beispielhaft beschrieben werden.

Es zeigen:
- Figur 1: in der Prinzipansicht einen erfindungsgemäßen Spiegel
- Figuren 2a - 2b: eine Detailansicht einer Oberfläche mit einer Oberflächenwelle unterschiedlicher Wellenlänge zu verschiedenen Zeiten
- Figur 3: die Intensität über dem Beugungswinkel einer erfindungsgemäßen Anordnung
- Figur 4: zweidimensionale Anordnung von Interdigital Wandlem auf einer zu erregenden Oberfläche zur Erzeugung eines zweidimensionalen Wellenfeldes
- Figur 5: die Anordnung mehrerer nebeneinander liegender Einzelbauteile zu einem Gesamtbauteil zur Erzeugung einer Oberflächenwelle über einen grösseren Bereich
- Figur 6: Ausführungsform einer Spiegeloberfläche zur Erzeugung von Oberflächenwellen
- Figur 7: Verwendung einer erfindungsgemäßen Spiegelvorrichtung zur Strahlaufweitung im Strahlengang eines Beleuchtungssystems für die EUV-Lithographie mit Undulator-Lichtquelle
- Figur 8: Verwendung eines erfindungsgemäßen Spiegels zur Verschmierung des Intensitätspeaks der sekundären Lichtquellen eines EUV-Belichtungssystems.

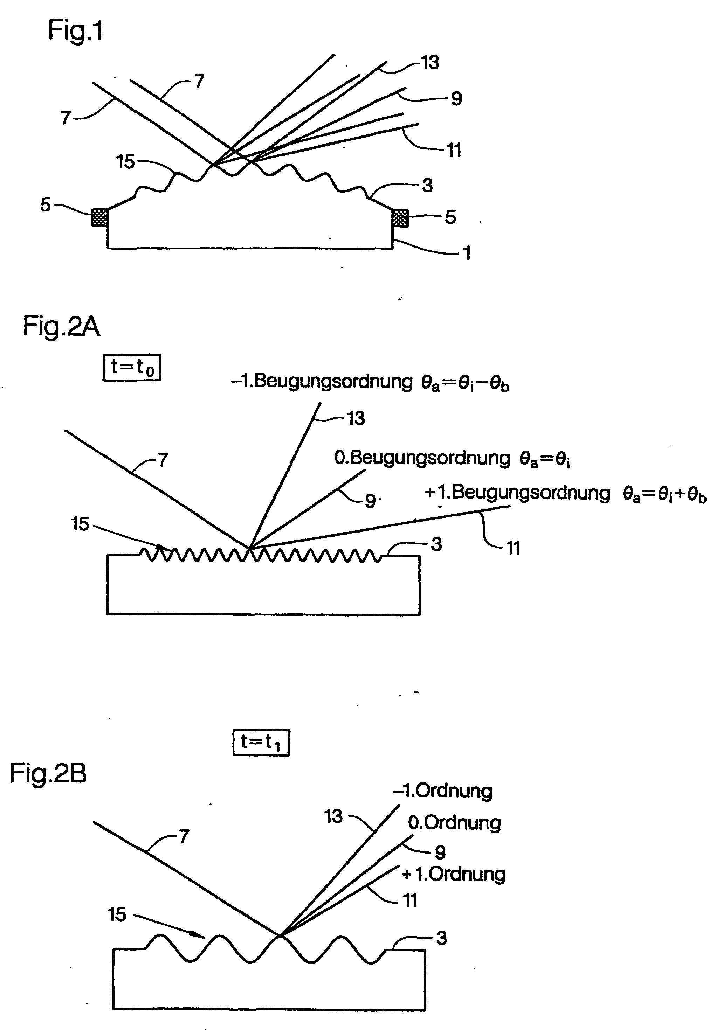

In Figur 1 ist der prinzipielle Aufbau einer optischen Vorrichtung gemäß der Erfindung dargestellt. Im vorliegenden Fall umfaßt die optische Vorrichtung einen Spiegel 1 mit einer bspw. superpolierten Spiegeloberfläche 3 sowie Einrichtungen 5 zur Erzeugung von Schwingungen der Spiegeloberfläche, beispielsweise Interdigitalelektroden.

Die Schwingungsfrequenz mit der die Einrichtungen 5 die Spiegeloberfläche 3 zu Schwingungen anregen, ist derart gewählt, daß die auf die Spiegeloberfläche 3 auftreffende Strahlung 7 in einen vorbestimmten Bereich gebeugt wird. In Figur 1 ist die 0. Beugungsordnung 9, die 1. Beugungsordnung 11 sowie die -1. Beugungsordnung 13 der einfallenden Strahlung 7 dargestellt.

Beugung ist durch die Interferenz vieler an einer periodischen Struktur, vorliegend der Oberflächenwelle 15, reflektierter Strahlen 7 gekennzeichnet. Um einen Beugungseffekt gemäß der Erfindung hervorzurufen, ist die Frequenz der Oberflächenwelle 15 derart gewählt, daß das einfallende Licht 7 eine große Anzahl von Gitterlinien, die durch die Oberflächenwelle 15 aufgebaut werden, trifft. Die Anzahl der Gitterlinien, die vom einfallenden Licht 7 getroffen werden, das heißt die Maxima der Oberflächenwelle 15, sollte mehr als 100 betragen.

In den Figuren 2a und 2b ist nochmals detailliert die Beugung an einer durch die Oberflächenwellen periodisch veränderten Oberflächenstruktur zu unterschiedlichen Zeiten t=t₀ und t = t₁ dargestellt.

Sowohl in Figur 2a wie Figur 2b wurde für gleiche Gegenstände wie in Figur 1 dieselben Bezugszeichen gewählt. Bezugsziffer 7 bezeichnet den auf die Oberfläche einfallenden Strahl, Bezugsziffer 9 den Strahl 0. Beugungsordnung, bei dem der Ausfallswinkel gleich dem Einfallswinkel, d.h. θₐ = θᵢ ist, Bezugsziffer 11 die 1. Beugungsordnung, bei der der Ausfallswinkel θₐ = θᵢ + θ_{b} ist, wobei θ_{b} der Winkel der ersten Beugungsordnung in Abhängigkeit von der Gitterkonstanten der Oberflächenwelle ist und 13 den Strahl der -1. Beugungsordnung unter dem Winkel θₐ = θᵢ - θ_{b}.

Wird nun die Frequenz der Oberflächenwelle 15 über die Zeit variiert, das heißt die Wellenlänge der Oberflächenwelle und damit der durch die Oberflächenwelle erzeugte Gitterabstand" so wird die 1. und -1. Ordnung in einen anderen Winkelbereich gebeugt. Dies ist gut Figur 2b zu entnehmen, wobei die Wellenlänge und damit der Gitterabstand zum Zeitpunkt t = t₁ vergrößert wurde. Die +1. Ordnung und - 1. Ordnung wird in einen kleineren Winkelbereich als bei geringerem Gitterabstand, das heißt kürzeren Wellenlängen wie in Figur 2a, zur Zeit t = t₀ dargestellt..

Wie die Figuren 2a und 2b zeigen, ist es somit möglich, durch eine kontinuierliche Variation der Frequenz der Oberflächenwelle eine im zeitlichen Mittel homogene Ausleuchtung eines Winkelbereiches mit Hilfe der erfindungsgemäßen Vorrichtung zu erreichen. Die Wellenlänge der eingesetzten Oberflächenwellen zur Erzeugung der kontinuierlichen Ausleuchtung eines Winkelbereiches von beispielweise ± 12 mrad liegt im Bereich 1 µm bis 50 µm, die Amplitude der Oberflächenwelle im Bereich 1 nm bis 100 nm. Da in der Praxis ein Wellenzug der Oberflächenwelle die durch die Oberflächenwelle angeregte, d.h. aktive Spiegeloberfläche 15, die bevorzugt im Bereich von 10 mm bis 100 mm liegt, in ca. 10 µs durchläuft, können bei einer Belichtungszeit von 1 ms ca. 1000 Frequenzen durchfahren werden. Es ergibt sich dann ein durchstimmbarer Winkelbereich des Ablenkwinkels von ± 12 mrad.

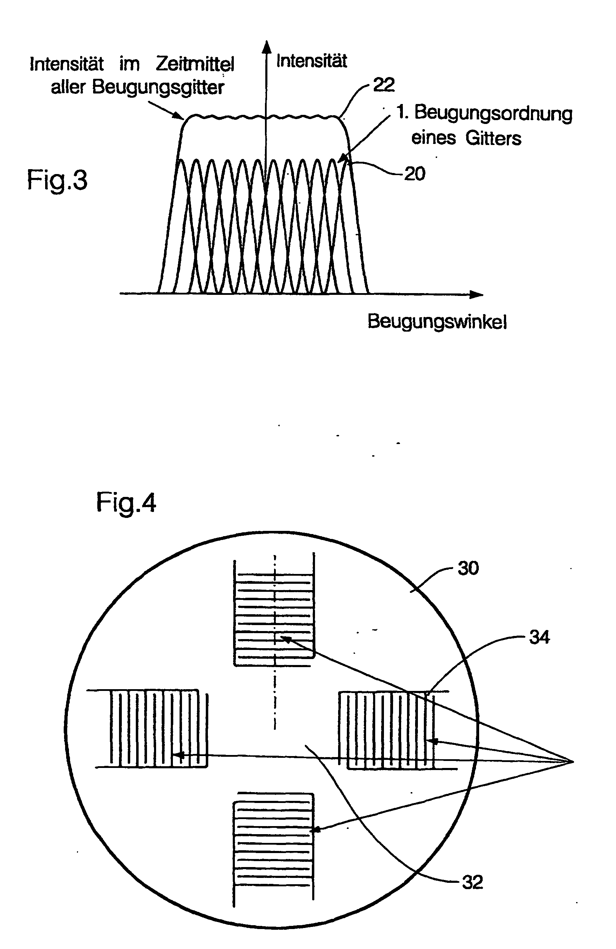

Die mit Hilfe der erfindungsgemäßen Vorrichtung, bei der die Frequenz der Oberflächenwelle kontinuierlich variiert wird, um alle Beugungswinkel einer monochromatischen Quelle von 0 mrad bis ± 12 mrad einzustellen,erzielbare Intensitätsverteilung ist in Figur 3 dargestellt. Mit Bezugsziffer 20 ist die Intensität der ersten Beugungsordnung eines beispielhaft ausgewählten Gitters dargestellt. Bezugsziffer 22 bezeichnet die Intensität im Zeitmittel aller Beugungsgitter, die sich bei Durchstimmung der Frequenzen ergeben. Wie hieraus deutlich zu erkennen ist, zeigt der Intensitätsverlauf aufgetragen über dem Beugungswinkel ein Hut-Profil, das heißt bis auf geringe Schwankungen ist die Intensität über den gesamten Winkelbereich im wesentlichen konstant.

Im Gegensatz zur Beugung gilt im Falle der reinen Reflexion die Beziehung Einfallswinkel = Ausfallwinkel. Für den Fall der Reflexion trifft das einfallende Licht so auf, daß es weniger als eine Wellenlänge bis maximal eine Wellenlänge des durch die Oberflächenwelle erzeugten Gitters ausleuchtet. Eine laufende Oberflächenwelle erzeugt in einem derartigen Fall lediglich eine kontinuierliche Veränderung des Reflexionswinkels. Zwar kann auf diese Art und Weise ebenfalls ein vorbestimmter Winkelbereich überstrichen werden, jedoch wird im Falle der Reflexion der einstellbare Winkelbereich, nicht homogen durchfahren. Dies wiederum hat zur Folge, daß im Gegensatz zur Erfindung eine homogene Ausleuchtung nicht erzielt werden kann.

In Figur 4 ist eine Ausführungsform der Erfindung dargestellt, die es erlaubt, einen auf die Spiegeloberfläche 30 einfallenden Strahl in zwei Dimensionen zu modifizieren. Dies kann dadurch erreicht werden, daß Oberflächenwellen an mehreren Orten der Spiegelfläche parallel oder nichtparallel auf die aktive Fläche 32 gebracht werden. Zur Anregung derartiger Wellen sind in der Ausführungsform gemäß Figur 4 insgesamt vier Anregungseinrichtungen. 34 sogenannte Interdigitalwandler, d. h. Elektroden auf der Spiegeloberfläche angeordnet.

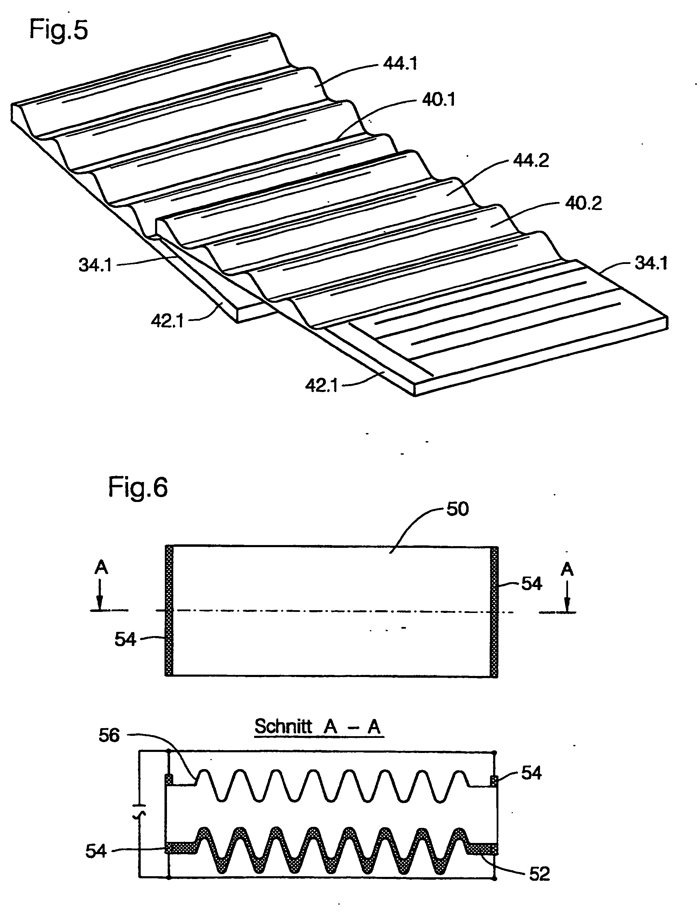

Um die aktive Fläche eines Bauteils zu vergrößern, kann gemäß der Ausführungsform in Figur 5 vorgesehen sein, das Bauteil, vorliegend die Spiegeloberfläche, aus mehreren Einzelbauteilen 40.1, 40.2, zusammenzusetzen.

Deutlich zu erkennen ist in Fig. 5 das Substrat 42.1, 42.2 sowie die auf dem jeweiligen Substrat angeordneten Anregungseinrichtungen 34.1, 34.2 für Oberflächenwellen 44.1, 44.2. Die Anregungseinrichtungen 34.1, 34.2 sind in dem vorliegenden Beispiel als Interdigitalelektroden ausgebildet. Durch Überlagerung der mittels der Interdigitatelektroden angeregten Oberflächenwellen 44.1, 44.2 kann der aktive Bereich eines Bauteils signifikant vergrößert werden.

In Figur 6 ist die technische Realisierung eines aktiven Bauelementes, das als Spiegeloberfläche 50 Verwendung finden kann, dargestellt. Eine PZT-Folie wird auf die rauhe Seite 52 beispielsweise einer Silizium-Waferscheibe mit einer atomaren Verbindungstechnik, beispielsweise einer TiPt-Verbindung, aufgebracht. An definierten Stellen werden punkt- oder linienförmige Elektroden 54 angeordnet. Mit diesen Elektroden können akustische Oberflächenwellen auf der sehr dünnen Waferscheibe erzeugt werden. Mit Hilfe der akustischen Oberflächenwellen wird ein ein- bzw. zweidimensionales Gitter erzeugt, welche wiederum die erfindungsgemäße Beugung eines einfallenden Lichtstrahles ermöglichen. Um möglichst große Amplituden erzeugen zu können, kann das System in Eigenresonanz versetzt werden. Die für die Anregung benötigten Frequenzen liegen im 100 - 10000 MHz-Bereich mit Leistungen von 1 - 200 Watt.

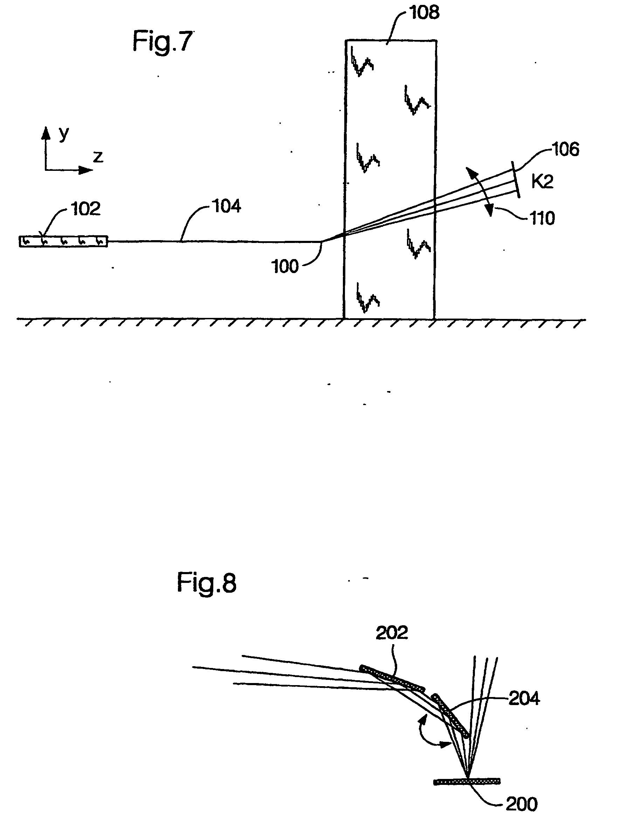

Die Figuren 7 und 8 zeigen die Verwendung eines erfindungsgemäßen optischen Bauteiles in einem Beleuchtungssystem für die EUV-Lithographie.

Betreffend den prinzipiellen Aufbau von EUV-Beleuchtungssystemen wird auf die anhängigen Anmeldungen EP 99106348.8, eingereicht am 02.03.1999 mit dem Titel "Beleuchtungssystem, insbesondere für die EUV-Lithographie", US-Seriell-No. 09/305,017, eingereicht am 04.05.1999 mit dem Titel "Elumination System particulary for EUV-Lithography" sowie PCT/EP 99/02999, eingereicht am 04.05.1999 mit dem Titel "Beleuchtungssystem, insbesondere für die EUV-Lithographie" sowie die Anmeldung DE 29915847.0, eingereicht am 03.09.1999 mit dem Titel "Steuerung der Beleuchtungsverteilung in der Austrittspupille eines EUV-Beleuchtungssystems" verwiesen.

In Figur 7 ist in schematischer Darstellung ein Beleuchtungssystem dargestellt, bei dem der Kollektorspiegel 100, der den von der Synchrotron-Strahlungsquelle 102, beispielsweise einer Undulator-Quelle kommenden Strahl 104, aufweitet.Der Kollektorspiegel ist als Spiegel mit einer periodisch sich ändernden Oberfläche ergebend Beugungseffekte gemäß der Erfindung ausgebildet. Durch einen derartigen Spiegel läßt sich der Kollektorspiegel 106, der nahe der Strahlenschutzwand 108 liegt, im Winkelbereich 110 bspw. von - 12,0 mrad < α <12,0 mrad ausleuchten.

In Figur 8 ist wiederum ein Ausschnitt eines Beleuchtungssystems dargestellt, und zwar der Teil des Beleuchtungssystems, der dazu dient, das von der Lichtquelle erzeugte Bild des Retikel auf die Waferoberfläche 200 zu lenken, sowie das Ringfeld zu formen. Eine derartige Anordnung umfaßt in dem in Figur 8 gezeigten Beispiel zwei Feldspiegel 202, 204. Der zweite der beiden Feldspiegel 204 ist als Spiegel mit deformierbarer Oberfläche gemäß der Erfindung ausgebildet. Ein derartiger Spiegel dient dazu, um in der Intensitätsverteilung der Retikelebene die Diskretisierung der Einzelwabe zu vermeiden. Der Spiegel 204 bewirkt im zeitlichen Mittel ein Verschmieren der von den sekundären Lichtquellen, die als Einzelwaben ausgebildet sind, punktförmige Lichtstrahlen und sorgt so für eine gleichmäßige Ausleuchtung des Ringfeldes.

In der vorliegenden Erfindung wird somit erstmals eine optische Vorrichtung zur gleichmäßigen Ausleuchtung eines vorbestimmten Winkelbereiches angegeben, die insbesondere für eine Verwendung in Beleuchtungssystemen für die EUV-Lithographie geeignet sind.

## Patentansprüche

1. Optische Vorrichtung für Strahlung mit einer Wellenlänge ≤ 160 nm, vorzugsweise EUV-Strahlung mit
Einem Spiegel (1) mit einer Spiegeloberfläche (3)
Einer Einrichtung (5) zur Erzeugung von elastischen Schwingungen der Spiegeloberfläche aufgrund von Oberflächendeformationen,
wobei die Einrichtung (5) zur Erzeugung von elastischen Schwingungen akustische Oberflächenwellen (15) auf der Spiegeloberfläche (3) erzeugt und die Spiegeloberfläche (3) durch die akustischen Oberflächenwellen (15) in ein Beugungsgitter für die auftreffende Strahlung transformiert wird.
**dadurch gekennzeichnet, dass**
auf die Außenseite der Spiegeloberfläche auftreffende Strahlung (7) in einen vorbestimmten Wenkelbereich (α) gebeugt wird, wobei die Wellenlänge der Oberflächenwelle (15) im Bereich 1 µm bis 50 µm sowie die Amplitude der Oberflächenwelle (15) im Bereich 1 nm bis 100 nm liegt und die Frequenz der Oberflächenwelle (15) variiert wird, so dass im zeitlichen Mittel eine homogene Ausleuchtung des vorgegebenen Winkelbereichs erreicht wird.

2. Optische Vorrichtung gemäß Anspruch 1,
**dadurch gekennzeichnet, dass**
die Frequenz der Oberflächenwelle kontinuierlich oder diskret variiert wird.

3. Optische Vorrichtung gemäß Anspruch 1 oder 2,
**dadurch gekennzeichnet, dass**
an mehreren Orten der Spiegeloberfläche (30) Einrichtungen (34) zur Erzeugung elastischer Schwingungen vorgesehen sind, so dass akustische Oberflächenwellen parallel oder nicht parallel auf die aktive Spiegeloberfläche gebracht werden können.

4. Optische Vorrichtung gemäß Anspruch 3,
**dadurch gekennzeichnet, dass**
die aktive Spiegeloberfläche sich aus mehreren Einzelbauteilen (40.1, 40.2, 40.3) zusammensetzt.

5. Optische Vorrichtung nach einem der Ansprüche 1 bis 4,
**dadurch gekennzeichnet, dass**
die Einrichtung zur Erzeugung elastischer Schwingungen der Spiegeloberfläche eine piezoelektrische Folie umfasst.

6. Optische Vorrichtung nach Anspruch 5,
**dadurch gekennzeichnet, dass**
die piezoelektrische Folie auf der einen, rauen Seite (52) eines ausreichend dünnen Substrates aufgebracht wird, wobei die andere Seite (50) des Substrates die Spiegeloberfläche für die auftreffende Strahlung ausbildet.

7. Optische Vorrichtung nach einem der Ansprüche 5 bis 6,
**dadurch gekennzeichnet, dass**
die piezoelektrische Folie eine große PZT-Folie und das Substrat Si-Substrat ist, auf dem die PZT-Folie mit teils atomarer Verbindungstechniken aufgebracht wird.

8. Optische Vorrichtung nach einem der Ansprüche 1 bis 7,
**dadurch gekennzeichnet, dass**
die Einrichtungen zur Erzeugung elastischer Schwingungen einen piezoelektrischen Einkristall umfassen.

9. Optische Vorrichtung nach einem der Ansprüche 5 bis 8,
**dadurch gekennzeichnet, dass** die Einrichtungen zur Erzeugung elastsicher Schwingungen punkt- oder linienförmige Elektroden umfassen.

10. Verwendung einer optischen Vorrichtung gemäß einem der Ansprüche 1 bis 9, zur Ausleuchtung eines vorgegebenen Winkelbereiches durch eine Lichtquelle mit einer Wellenlänge ≤ 160 nm, vorzugsweise einer EUV-Lichtquelle, wobei
Mindestens eine Oberflächenwelle vorbestimmter Amplitude und Frequenz erzeugt wird und die Frequenz derart gewählt wird, dass das von der Lichtquelle einfallende Licht eine große Anzahl von durch die Oberflächenwelle erzeugten Gitterlinien trifft und die Frequenz der Oberflächenwelle in einem vorbestimmten Frequenzbereich variiert wird, so dass im zeitlichen Mittel eine homogene Ausleuchtung eines vorgegebenen Winkelbereiches erreicht wird.

11. Verwendung nach Anspruch 10,
**dadurch gekennzeichnet, dass**
der Winkelbereich -12,0 ≤ α ≤ 12,0 mrad beträgt.

12. Verwendung einer optischen Vorrichtung gemäß Anspruch 10,
**dadurch gekennzeichnet, dass**
dieses als optisches Bauteil in einer Belichtungseinrichtung für die Lithographie mit Wellenlängen ≤ 160 nm, insbesondere im EUV-Bereich, eingesetzt wird.

13. Verwendung einer optischen Vorrichtung gemäß Anspruch 12,
**dadurch gekennzeichnet, dass**
das optische Bauteil in der Beleuchtungseinrichtung zur Strahlaufweitung der Lichtquelle dient.

14. Verwendung einer optischen Vorrichtung gemäß Anspruch 12,
**dadurch gekennzeichnet, dass**
das optische Bauteil in der Beleuchtungseinrichtung für Variationen des Beleuchtungssettings dient.

15. Verwendung einer optischen Vorrichtung gemäß Anspruch 12,
**dadurch gekennzeichnet, dass**
das optische Bauteil in der Beleuchtungseinrichtung zur Homogenisierung der Ausleuchtung der Pupille verwendet wird.

16. Verfahren zur Herstellung einer optischen Vorrichtung gemäß einem der Ansprüche 5 bis 7, umfassend folgende Schritte:
16.1. eine Seite eines Substrates ergebend die Spiegeloberfläche wird superpoliert, so dass die Oberflächenrauhigkeit weniger als 0,5 nm beträgt,
16.2. **dadurch gekennzeichnet, dass** an dem Substrat Elektroden angebracht werden.

17. Verfahren gemäß Anspruch 16,
**dadurch gekennzeichnet, dass**
die Elektroden auf der superpolierten Oberfläche angebracht werden.

## Claims

1. Optical device for radiation with a wavelength of ≤ 160 nm, preferably EUV radiation, with
a mirror (1) with a mirror surface (3)
a unit (5) for producing elastic oscillations of the mirror surface based on surface deformations,
wherein the unit (5) for producing elastic oscillations produces acoustic surface waves (15) at the mirror surface (3) and the mirror surface (3) is transformed by the acoustic surface waves (15) into a diffraction grating for the incident radiation,
**characterised in that**
radiation (7) incident on the outside of the mirror surface is diffracted in a predetermined angular region (α), wherein the wavelength of the surface wave (15) is in the range 1 µm to 50 µm and the amplitude of the surface wave (15) is in the range 1 nm to 100 nm and the frequency of the surface wave (15) is varied so that homogeneous illumination of the specified angular region is achieved on average over time.

2. Optical device according to Claim 1,
**characterised in that**
the frequency of the surface wave is varied continuously or discretely.

3. Optical device according to Claim 1 or 2,
**characterised in that**
units (34) for the production of elastic oscillations are provided at several locations on the mirror surface (30), so that acoustic surface waves can be brought parallel or non-parallel to the active mirror surface.

4. Optical device according to Claim 3,
**characterised in that**
the active mirror surface is composed of several individual components (40.1, 40.2, 40.3).

5. Optical device according to one of Claims 1 to 4,
**characterised in that**
the unit for producing elastic oscillations of the mirror surface comprises a piezo-electric film.

6. Optical device according to Claim 5,
**characterised in that**
the piezo-electric film is applied to the one, rough side (52) of a sufficiently thin substrate, the other side (5= (sic)) of the substrate forming the mirror surface for the incident radiation.

7. Optical device according to one of Claims 5 to 6,
**characterised in that**
the piezo-electric film is a large PZT film and the substrate is Si substrate to which the PZT film is applied using partially atomic bonding techniques.

8. Optical device according to one of Claims 1 to 7,
**characterised in that**
the units for producing elastic oscillations comprise a piezo-electric single crystal.

9. Optical device according to one of Claims 5 to 8,
**characterised in that**
the units for producing elastic oscillations comprise electrodes in the form of a point or line.

10. Use of an optical device according to one of Claims 1 to 9, for the illumination of a specified angular region by a light source with a wavelength of ≤ 160 nm, preferably an EUV light source, wherein at least one surface wave of predetermined amplitude and frequency is produced and the frequency is so chosen that the light incident from the light source impinges on a large number of grid lines produced by the surface wave and the frequency of the surface wave is varied in a predetermined frequency range so that homogeneous illumination of a specified angular region is achieved on average over time.

11. Use according to Claim 10,
**characterised in that**
the angular region is -12.0 ≤ α ≤ 12.0 mrad.

12. Use of an optical device according to Claim 10,
**characterised in that**
this is used as an optical component in a lighting unit for lithography with wavelengths of ≤ 160 nm, in particular in the EUV range.

13. Use of an optical device according to Claim 12,
**characterised in that**
the optical component serves to widen the beam of the light source in the illumination unit.

14. Use of an optical device according to Claim 12,
**characterised in that**
the optical component in the illumination unit serves for variations in the illumination setting.

15. Use of an optical device according to Claim 12,
**characterised in that**
the optical component in the illumination unit is used to homogenise the illumination of the pupil.

16. Method for the production of an optical device according to one of Claims 5 to 7, comprising the following steps:
16.1 one side of a substrate providing the mirror surface is super-polished so that the surface roughness is less than 0.5 nm,
16.2 **characterised in that** electrodes are applied to the substrate.

17. Method according to Claim 16,
**characterised in that**
the electrodes are applied to the super-polished surface.

## Revendications

1. Dispositif optique pour un rayonnement avec une longueur d'onde ≤ 160 nm, de préférence un rayonnement EUV, comportant
un miroir (1) avec une surface (3) de miroir ;
un dispositif (5) pour la génération d'oscillations élastiques de la surface de miroir engendrées par des déformations de surface ;
le dispositif (5) pour la génération d'oscillations élastiques générant des ondes acoustiques de surface (15) à la surface (3) de miroir, et la surface (3) de miroir étant transformée par les ondes acoustiques de surface (15) en un réseau de diffraction pour le rayonnement incident,
**caractérisé en ce que**
le rayonnement (7) arrivant sur la face extérieure de la surface de miroir est diffracté dans une zone angulaire (α) prédéterminée, la longueur d'onde de l'onde de surface (15) se situant dans la plage de 1 µm à 50 µm, et l'amplitude de l'onde de surface (15) dans la plage de 1 nm à 100 nm, et la fréquence de l'onde de surface (15) étant variée, de sorte qu'un éclairage homogène de la plage angulaire prédéterminée soit obtenu en moyenne temporelle.

2. Dispositif optique selon la revendication 1,
**caractérisé en ce que** la fréquence de l'onde de surface est variée en continu ou de façon discrète.

3. Dispositif optique selon la revendication 1 ou 2,
**caractérisé en ce que** des dispositifs (34) pour la génération d'oscillations élastiques sont prévus au niveau de plusieurs emplacements de la surface (30) de miroir, de sorte que des ondes acoustiques de surface peuvent être dirigées parallèlement ou non parallèlement sur la surface active de miroir.

4. Dispositif optique selon la revendication 3,
**caractérisé en ce que** la surface active de miroir est constituée de plusieurs composants individuels (40.1, 40.2, 40.3).

5. Dispositif optique selon l'une des revendications 1 à 4,
**caractérisé en ce que** le dispositif pour la génération d'oscillations élastiques de la surface de miroir comporte un film piézoélectrique.

6. Dispositif optique selon la revendication 5,
**caractérisé en ce que** le film piézoélectrique est appliqué sur une face rugueuse (52) d'un substrat suffisamment mince, l'autre face (5=) du substrat constituant la surface de miroir pour le rayonnement incident.

7. Dispositif optique selon l'une des revendications 5 à 6,
**caractérisé en ce que** le film piézoélectrique est un grand film PZT, et **en ce que** le substrat est un substrat de Si sur lequel le film PZT est appliqué avec des techniques de liaison atomiques partielles.

8. Dispositif optique selon l'une des revendications 1 à 7,
**caractérisé en ce que** les dispositifs pour la génération d'oscillations élastiques comportent un monocristal piézoélectrique.

9. Dispositif optique selon l'une des revendications 5 à 8,
**caractérisé en ce que** les dispositifs pour la génération d'oscillations élastiques comportent des électrodes en forme de points ou de lignes.

10. Utilisation d'un dispositif optique selon l'une des revendications 1 à 9 pour l'éclairage d'une zone angulaire prédéterminée par une source lumineuse avec une longueur d'onde ≤ 160 nm, de préférence une source lumineuse EUV,
au moins une onde de surface d'amplitude et de fréquence prédéterminées étant générée, et la fréquence étant choisie de telle sorte que la lumière incidente de la source lumineuse arrive sur un grand nombre de lignes de réseau générées par l'onde de surface, et
la fréquence de l'onde de surface étant variée dans une plage de fréquence prédéterminée, de sorte qu'un éclairage homogène d'une plage angulaire prédéterminée soit obtenu en moyenne temporelle.

11. Utilisation selon la revendication 10,
**caractérisée en ce que** la zone angulaire est de - 12,0 ≤ α ≤ 12,0 mrad.

12. Utilisation d'un dispositif optique selon la revendication 10,
**caractérisée en ce que** celui-ci est utilisé en tant que composant optique dans un dispositif d'exposition pour la lithographie avec des longueurs d'onde ≤ 160 nm, notamment dans la plage EUV.

13. Utilisation d'un dispositif optique selon la revendication 12,
**caractérisée en ce que** le composant optique sert dans le dispositif d'exposition à l'élargissement du rayonnement de la source lumineuse.

14. Utilisation d'un dispositif optique selon la revendication 12,
**caractérisée en ce que** le composant optique sert dans le dispositif d'exposition à des variations du réglage de l'éclairage.

15. Utilisation d'un dispositif optique selon la revendication 12,
**caractérisée en ce que** le composant optique sert dans le dispositif d'exposition à l'homogénéisation de l'éclairage de la pupille.

16. Procédé destiné à la fabrication d'un dispositif optique selon l'une des revendications 5 à 7, comportant les phases suivantes :
16.1 une face d'un substrat devenant la surface de miroir est superpolie, de sorte que la rugosité de surface est inférieure à 0,5 nm,
16.2 **caractérisé en ce que** des électrodes sont fixées sur le substrat.

17. Procédé selon la revendication 16,
**caractérisé en ce que** les électrodes sont fixées sur la surface superpolie.
